# EUROPÄISCHE PATENTSCHRIFT

(11) **EP 3 171 473 B1**
(45) Veröffentlichungstag und Bekanntmachung des Hinweises auf die Patenterteilung: **21.04.2021**
(21) Anmeldenummer: 15194882.5
(22) Anmeldetag: 17.11.2015
(51) Int. Cl.: H02H 3/05, G01R 31/327, G01R 31/333, H01H 9/54, H01H 33/59, H02H 3/04

(54) **VERFAHREN UND SCHUTZEINRICHTUNG ZUM ÜBERWACHEN EINES LEISTUNGSSCHALTERS IN EINEM ELEKTRISCHEN ENERGIEVERSORGUNGSNETZ**
METHOD AND PROTECTION DEVICE FOR MONITORING A POWER CIRCUIT BREAKER IN AN ELECTRICAL ENERGY SUPPLY NETWORK
PROCEDE ET DISPOSITIF DE PROTECTION DESTINES A SURVEILLER UN DISJONCTEUR DANS UN RESEAU D'ALIMENTATION EN ENERGIE ELECTRIQUE

(43) Veröffentlichungstag der Anmeldung: 24.05.2017
(73) Patentinhaber: Siemens Aktiengesellschaft, 80333 München (DE)
(72) Erfinder: Blumschein, Jörg, 14165 Berlin (DE); Neugebauer, Olaf, 16562 Bergfelde (DE); Yelgin, Yilmaz, 13589 Berlin (DE)

(56) Entgegenhaltungen:
- WO-A1-99/21146
- DE-T2- 69 728 475
- US-A- 5 710 542

## Beschreibung

Die Erfindung betrifft ein Verfahren gemäß Anspruch 1 zum Überwachen eines Leistungsschalters in einem elektrischen Energieversorgungsnetz. Bei dem Verfahren wird ein Abschnitt des elektrischen Energieversorgungsnetzes hinsichtlich des Auftretens eines Fehlers überwacht, wobei bei Erkennung eines Fehlers auf dem überwachten Abschnitt ein Auslösesignal an einen den Abschnitt begrenzenden Leistungsschalter abgegeben wird, und ein einen Fehler beim Öffnen des Leistungsschalters angebendes Schalter-Fehlersignal erzeugt wird, wenn nach der Abgabe des Auslösesignals ein andauernder Stromfluss durch den Leistungsschalter erkannt wird, wobei zum Erkennen eines andauernden Stromflusses eine Kurvenform des zeitlichen Verlaufs des durch den Leistungsschalter fließenden Momentanstroms untersucht wird und die Kurvenform des zeitlichen Verlaufs des durch den Leistungsschalter fließenden Momentanstroms hinsichtlich des Vorliegens mindestens eines die Kurvenform charakterisierenden Kriteriums untersucht wird und anhand des Kriteriums auf einen andauernden oder einen unterbrochenen Stromfluss geschlossen wird.

Ein solches Verfahren ist beispielsweise aus der US 5,710,542 bekannt.

Die Erfindung betrifft auch eine Schutzeinrichtung gemäß Anspruch 12 zum Überwachen eines Leistungsschalters mit einer entsprechend eingerichteten Steuereinrichtung.

Elektrische Energieversorgungsnetze werden hinsichtlich ihres Betriebszustands üblicherweise mit sogenannten Schutzgeräten überwacht. Solche Schutzgeräte werten unter Verwendung sogenannter Schutzalgorithmen (z.B. Distanzschutzalgorithmus, Differentialschutzalgorithmus, Überstromschutzalgorithmus) Messwerte (z.B. Ströme und/oder Spannungen) aus, die einen Betriebszustand des Energieversorgungsnetzes an einer jeweiligen Messstelle angeben. Als Ergebnis der Auswertung trifft ein Schutzgerät eine Entscheidung darüber, ob sich der von ihm überwachte Abschnitt des Energieversorgungsnetzes in einem zulässigen oder unzulässigen Betriebszustand befindet. Sofern ein unzulässiger Betriebszustand, der beispielsweise durch einen vorliegenden Kurzschluss hervorgerufen sein kann, erkannt wird, gibt das Schutzgerät ein Auslösesignal an einen den fehlerbehafteten Abschnitt des Energieversorgungsnetzes begrenzenden Leistungsschalter ab, um diesen zum Öffnen seiner Schaltkontakte zu veranlassen und damit den fehlerbehafteten Abschnitt vom restlichen Energieversorgungsnetz abzutrennen.

Dabei ist sicherzustellen, dass der Leistungsschalter den Abschnitt auch tatsächlich abschaltet, da andernfalls Schäden an Komponenten des Energieversorgungsnetzes entstehen können. Außerdem besteht bei einem nicht abgeschalteten Fehler das Risiko der Verletzung von Personen.

Daher wird üblicherweise von den Schutzgeräten selbst oder von separaten Einrichtungen eine sogenannte Schalterversagerschutzfunktion ausgeführt, die eine Überwachung des ordnungsgemäßen Öffnens eines Leistungsschalters nach Abgabe eines Auslösesignals vornimmt. Lässt sich die Abschaltung nicht ausführen, z.B. durch einen defekten Leistungsschalter oder eine fehlerhafte Übermittlung des Auslösesignals, werden durch die Schalterversagerschutzfunktion geeignete Maßnahmen getroffen, um einen sicheren Zustand des fehlerbehafteten Abschnitts des Energieversorgungsnetzes herbeizuführen. Solche Maßnahmen können in einem erneuten Versuch, den Leistungsschalter zu öffnen bestehen. Darüber hinaus können auch weitere Leistungsschalter angesteuert werden, die dazu geeignet sind, den fehlerbehafteten Abschnitt abzuschalten.

Die Schalterversagerschutzfunktion muss sehr schnell eine Entscheidung darüber treffen können, ob der Leistungsschalter auf das Auslösesignal korrekt reagiert hat, um die Netzstabilität zu sichern. Dafür ist eine schnelle und sichere Erkennung erforderlich, ob der Leistungsschalter den Stromfluss tatsächlich unterbrochen hat. Nur bei einem andauernden Stromfluss durch den Leistungsschalter darf eine Fehlfunktion des Leistungsschalters erkannt werden, da andernfalls die Gefahr einer unnötigen Abschaltung weiterer Teile des Energieversorgungsnetzes besteht. Zu diesem Zweck kann entweder eine Überwachung von Hilfskontakten des Leitungsschalters vorgenommen oder der Stromfluss durch den Leistungsschalter durch Messung überwacht werden.

Aus dem Aufsatz "The Optimization of 500kV Breaker Failure Protection"; Jiang, Y. et al, 2014 China International Conference on Electricity Distribution (CICED 2014), Shenzhen, 23.-26. September 2014, ist ein Verfahren zur Überwachung eines Leistungsschalters bekannt, bei dem zur Erkennung, ob ein andauernder Stromfluss durch den Leistungsschalter stattfindet, ein Stromsignal mittels einer Fouriertransformation zunächst in den Frequenzbereich transformiert und dann analysiert wird. Die Transformation in den Frequenzbereich verzögert hierbei Zeitdauer, innerhalb der eine Entscheidung über die korrekte Funktion des Leistungsschalters getroffen werden kann.

Aus der US 5,157,575 A ist zudem ein Verfahren zur Überwachung eines Leistungsschalters bekannt, bei der ein andauernder Stromfluss mittels eines Überstromelements erkannt wird, das den durch den Leistungsschalter fließenden Strom mit einem Schwellenwert vergleicht. Um auch bei langsam abklingenden Gleichstromgliedern eine zuverlässige Aussage über den Zustand des Leitungsschalters treffen zu können, müssen hierbei vergleichsweise lange Untersuchungszeitdauern eingestellt werden, wodurch das Verfahren insgesamt langsamer wird.

Aus der WO 99/21146 A1 ist ein Verfahren bekannt, bei dem als Kriterium eine Periodizität des Verlaufs untersucht wird und auf ein Andauern des Stromflusses durch den Leistungsschalter geschlossen wird, wenn eine Periodizität des Verlaufs erkannt wird. Der Erfindung liegt die Aufgabe zugrunde, bei der Überwachung eines Leistungsschalters einen andauernden Stromfluss bzw. eine Unterbrechung des Stromflusses möglichst schnell und zuverlässig zu erkennen.

Diese Aufgabe wird durch ein Verfahren gemäß Anspruch 1 gelöst. Dadurch dass bei dem erfindungsgemäßen Verfahren der zeitliche Verlauf des Momentanstroms betrachtet wird, also eine Analyse im Zeitbereich stattfindet, kann auf eine zeit- und rechenaufwendige Fouriertransformation verzichtet werden. Durch die Betrachtung des Verlaufs des Momentanstroms wird zudem die Kurvenform bewertet, so dass hierdurch eine deutlich flexiblere Auswertung des Stromflusses stattfinden kann als bei Verwendung eines bloßen Schwellenwertvergleichs. Ein weiterer Vorteil des erfindungsgemäßen Verfahrens besteht darin, dass bei der praktischen Umsetzung die zur Erfassung des Momentanstroms zu verwendende Abtastrate vergleichsweise gering gewählt werden kann. So wird eine Abtastrate von etwa 1 kHz als ausreichend zur Erfassung des Momentanstroms angesehen; Verfahren, die im Frequenzbereich arbeiten, benötigen häufig deutlich höhere Abtastraten, die bei Werten von über 3 kHz liegen können.

Die Untersuchung kann hierbei auf Basis eines jeweiligen Phasenstroms, eines Erdstroms oder eines Gegensystemstroms stattfinden.

Erfindungsgemäß ist vorgesehen, dass die Kurvenform des zeitlichen Verlaufs des durch den Leistungsschalter fließenden Momentanstroms hinsichtlich des Vorliegens mindestens eines die Kurvenform charakterisierenden Kriteriums untersucht wird, und anhand des Kriteriums auf einen andauernden oder einen unterbrochenen Stromfluss geschlossen wird.

Auf diese Weise können vorteilhaft eine oder mehrere charakteristische Eigenschaften des Momentanstrom-Verlaufs betrachtet und hinsichtlich der Frage ausgewertet werden, ob ein andauernder Stromfluss vorliegt oder ob der Stromfluss wie gewünscht unterbrochen worden ist. Im Verlauf des Momentanstroms können sowohl Kriterien, die auf eine Stromunterbrechung schließen lassen, als auch solche, die auf einen andauernden Stromfluss hinweisen, betrachtet werden. Letztere sind erforderlich, um falsch positive Schlussfolgerungen bei Auftreten von typischen Phänomenen im Momentanstrom-Verlauf, wie z.B. Sättigung, das Auftreten von harmonischen Oberschwingungen etc. zu vermeiden.

Konkret ist in diesem Zusammenhang vorgesehen, dass als Kriterium eine Periodizität des Verlaufs untersucht wird, und auf ein Andauern des Stromflusses durch den Leistungsschalter geschlossen wird, wenn eine Periodizität des Verlaufs erkannt wird.

Dem liegt die Erkenntnis zugrunde, dass eine Periodizität eines Momentanstrom-Verlaufs üblicherweise nur dann vorliegt, wenn der Stromfluss nicht unterbrochen worden ist. Somit kann durch Untersuchung des Verlaufs hinsichtlich einer Periodizität vergleichsweise leicht auf einen andauernden Stromfluss geschlossen werden. Eine vorliegende Periodizität kann zudem relativ schnell festgestellt werden, da bei üblichen sinusförmigen Signalen Merkmale, die auf eine Periodizität hinweisen, bereits innerhalb einer ¼ Periodendauer auftreten.

In diesem Zusammenhang kann vorteilhaft vorgesehen sein, dass die Periodizität des Verlaufs anhand von auftretenden lokalen Extrema und/oder Wendepunkten untersucht wird.

Solche Merkmale lassen einen vergleichsweise zuverlässigen und schnellen Rückschluss auf eine vorliegende Periodizität zu. Außerdem können sie durch Bildung der ersten und ggf. zweiten und dritten Ableitung des Verlaufs - bzw. die Berechnung der entsprechenden Differenzenquotienten - leicht ermittelt werden.

Erfindungsgemäß ist weiter vorgesehen, dass bei fehlender Periodizität des Verlaufs als ein weiteres Kriterium ein Abklingverhalten des Verlaufs untersucht wird, und auf eine Unterbrechung des Stromflusses durch den Leistungsschalter geschlossen wird, wenn ein Abklingverhalten des Verlaufs erkannt wird.

Auf diese Weise kann relativ schnell eine Kurvenform des Verlaufs erkannt werden, die auf eine Unterbrechung des Stromflusses hindeutet. Wird nämlich ein Stromfluss über die Kontakte eines Leistungsschalters unterbrochen, liegt häufig einerseits keine Periodizität mehr vor und andererseits klingt der Verlauf des gemessenen Momentanstroms durch Entladevorgänge kontinuierlich ab.

In diesem Zusammenhang kann vorgesehen sein, dass zur Erkennung eines Abklingverhaltens einerseits der Mittelwert des Verlaufs des Momentanstroms und andererseits der Gradient des Verlaufs des Momentanstroms untersucht werden, und bei positivem Mittelwert und negativem Gradienten oder bei negativem Mittelwert und positivem Gradienten auf ein vorliegendes Abklingverhalten geschlossen wird.

Durch die Betrachtung dieser einfach zu ermittelnden Merkmale des Verlaufs des Momentanstroms kann zudem eine zuverlässige Unterscheidung von durch eine Sättigung der Stromwandler hervorgerufenen Kurvenformen des Verlaufs stattfinden. Bei vorhandener Stromwandlersättigung liegt nämlich ein positiver Mittelwert gemeinsam mit einem positiven Gradienten (und umgekehrt) vor.

Eine weitere vorteilhafte Weiterbildung des erfindungsgemäßen Verfahrens sieht zudem vor, dass als ein weiteres Kriterium eine Amplitude des Verlaufs ermittelt wird, und auf eine Unterbrechung des Stromflusses durch den Leistungsschalter geschlossen wird, wenn die Amplitude des Verlaufs einen Amplituden-Schwellenwert unterschreitet.

Eine vergleichsweise kleine Amplitude des Verlaufs lässt nämlich ebenfalls auf eine vorhandene Unterbrechung des Stromflusses schließen.

Konkret kann in diesem Zusammenhang vorgesehen sein, dass die Amplitude als Spitze-Spitze-Amplitude des Verlaufs ermittelt wird.

Die Spitze-Spitze-Amplitude (Peak-to-Peak) bzw. der Signalhub lassen nämlich auch bei nicht vollständig sinusförmigen Verläufen oder bei einer Überlagerung des Verlaufs mit einem Gleichstromglied eine relativ zuverlässige Bestimmung der Amplitude des Signals zu.

Außerdem kann gemäß einer weiteren vorteilhaften Ausführungsform in diesem Zusammenhang vorgesehen sein, dass bei einer unter dem Amplituden-Schwellenwert liegenden Amplitude des Verlaufs auch dann auf eine Unterbrechung des Stromflusses geschlossen wird, wenn eine Periodizität des Verlaufs erkannt worden ist.

Hierdurch kann das Amplituden-Kriterium als vorrangiges Kriterium zur Beurteilung des Verlaufs des Momentanstroms festgelegt werden. Bei einer Unterbrechung des Stromflusses kann nämlich auch ein Verlauf des Momentanstroms mit deutlich reduzierter Amplitude gemeinsam mit einer weiterhin periodischen Kurvenform auftreten.

Eine weitere vorteilhafte Ausführungsform des erfindungsgemäßen Verfahrens sieht zudem vor, dass der Verlauf innerhalb eines vorgegebenen Zeitfensters untersucht wird, wobei die Länge des Zeitfensters adaptiv festgelegt wird.

Die Länge des Zeitfensters bestimmt nämlich einerseits die Geschwindigkeit, mit der eine Entscheidung über einen andauernden Stromfluss bzw. eine Unterbrechung des Stromflusses getroffen werden kann. Hierzu sollte das Zeitfenster möglichst kurz ausgebildet sein. Andererseits muss das Zeitfenster jedoch auch so lang gewählt werden, dass eine Entscheidung mit der nötigen Zuverlässigkeit getroffen werden kann. Beispielsweise im Fall auftretender Oberschwingungen kann nämlich auch bei einem andauernden Stromfluss über vergleichsweise lange Zeitdauern (z.B. im Bereich einer halben Periodendauer) ein flacher Verlauf des Momentanstroms, also z.B. ein nichtperiodischer Verlauf mit einer niedrigen Amplitude, auftreten, der bei Wahl eines zu kurzen Zeitfensters als Unterbrechung des Stromflusses gewertet werden könnte. Durch Verwendung eines Zeitfensters mit adaptiver Länge lässt sich beiden Anforderungen - Geschwindigkeit und Zuverlässigkeit - gerecht werden.

In diesem Zusammenhang kann konkret vorgesehen sein, dass zur adaptiven Festlegung der Länge des Zeitfensters die Untersuchung zunächst mit einer minimalen Länge des Zeitfensters begonnen wird, und die Länge des Zeitfensters so lange erhöht wird, wie während einer unmittelbar auf den Zeitpunkt der Abgabe des Ausschaltsignals folgenden Lernphase eine Unterbrechung des Stromflusses erkannt wird, wobei die Dauer der Lernphase in Abhängigkeit von der Reaktionszeit des Leistungsschalters festgelegt wird.

Bei dieser vorteilhaften Ausführungsform wird vorteilhaft die Erkenntnis genutzt, dass unmittelbar nach der Abgabe des Auslösesignals bis zur tatsächlichen Auslösung des Schalters eine schalterspezifische Reaktionszeit vergeht, innerhalb der der Stromfluss noch nicht unterbrochen sein kann. Sofern also anhand der oben genannten Kriterien innerhalb einer Lernphase mit solchermaßen bestimmter Dauer eine Unterbrechung des Stromflusses erkannt wird, kann diese nur auf eine - bezüglich des speziellen Verlaufs des Momentanstroms - zu kurze Wahl der Länge des Zeitfensters zurückzuführen sein. Das Zeitfenster ist daher entsprechend zu verlängern, bis eine Unterbrechung des Stromflusses nicht mehr festgestellt wird. Diese Anpassung des Zeitfensters muss jedoch innerhalb der Reaktionszeit des Leistungsschalters, typisch beispielsweise 50 ms (2,5 Periodendauern bei einer Nennfrequenz von 50Hz), abgeschlossen sein, so dass die Erhöhungsschritte der Länge des Zeitfensters entsprechend zu bemessen sind.

Gemäß einer weiteren vorteilhaften Ausführungsform des erfindungsgemäßen Verfahrens kann vorgesehen sein, dass die Untersuchung der Kurvenform des Verlaufs während einer maximalen Untersuchungsdauer wiederholt durchgeführt wird, und das Schalter-Fehlersignal erzeugt wird, wenn am Ende der maximalen Untersuchungsdauer ein andauernder Stromfluss festgestellt wird.

Hierdurch kann die Zuverlässigkeit der Erkennung weiter gesteigert werden, da die endgültige Entscheidung über die Erkennung eines andauernden oder unterbrochenen Stromflusses am Ende der maximalen Untersuchungsdauer - und damit auf Grundlage mehrerer Untersuchungsdurchgänge und nicht einer einzelnen Untersuchung - getroffen wird. Die maximale Untersuchungsdauer sollte hierbei einerseits derart lang bemessen sein, dass bei einem ungestörten Leistungsschalter üblicherweise eine Stromunterbrechung festgestellt werden kann und andererseits derart kurz bemessen sein, dass keine Schädigung des Energieversorgungsnetzes oder von Personen eintreten kann.

In diesem Zusammenhang kann gemäß einer weiteren vorteilhaften Ausführungsform des erfindungsgemäßen Verfahrens vorgesehen sein, dass die Auswahl der für die Untersuchung des Verlaufs zu betrachtenden Kriterien davon abhängt, ob in einem vorangehenden Durchgang der Untersuchung bereits eine Unterbrechung des Stromflusses erkannt worden ist.

Auf diese Weise kann nach Erkennung einer Stromflussunterbrechung ein vereinfachtes Untersuchungsverfahren eingesetzt werden, bei dem nur eine reduzierte Anzahl von Kriterien zur Beurteilung des Verlaufs betrachtet wird. Jedoch kann auch wieder auf den vollen Umfang aller Kriterien zurückgegangen werden, wenn erneut ein vorliegender Stromfluss erkannt worden ist.

Eine weitere vorteilhafte Ausführungsform des erfindungsgemäßen Verfahrens sieht schließlich vor, dass bei vorliegendem Schalter-Fehlersignal ein erneutes Auslösesignal an den Leistungsschalter abgegeben wird und/oder ein Hilfs-Auslösesignal an zumindest einen dem Leistungsschalter vorgelagerten weiteren Leistungsschalter abgegeben wird.
Auf diese Weise kann auch bei einem Ausbleiben des Öffnens des Leitungsschalters der fehlerbehaftete Abschnitt des Energieversorgungsnetzes zuverlässig abgeschaltet werden. So kann durch erneute Abgabe des Ausschaltsignals an den Leistungsschalter ein zweiter Versuch zum Öffnen unternommen werden. Alternativ oder zusätzlich kann auch ein Hilfs-Auslösesignal an vorgelagerte Leistungsschalter abgegeben werden, um den fehlerbehafteten Abschnitt sicher abzuschalten. Das Hilfs-Auslösesignal kann auch mit einer zeitlichen Verzögerung zum erneuten Auslösesignal für den lokalen Leistungsschalter abgegeben werden, um eine lokale Klärung des Fehlers zu begünstigen.

Die oben genannte Aufgabe wird auch durch eine Schutzeinrichtung gemäß Anspruch 12 zum Überwachen eines Leistungsschalters in einem elektrischen Energieversorgungsnetz gelöst. Die Schutzeinrichtung weist eine Steuereinrichtung auf, die dazu eingerichtet ist, ein einen Fehler beim Öffnen eines Leistungsschalters angebendes Schalter-Fehlersignal zu erzeugen, wenn nach der Abgabe des Auslösesignals für den Leistungsschalter ein andauernder Stromfluss durch den Leistungsschalter erkannt wird, wobei die Steuereinrichtung dazu eingerichtet ist, zum Erkennen eines andauernden Stromflusses eine Kurvenform des zeitlichen Verlaufs des durch den Leistungsschalter fließenden Momentanstroms zu untersuchen, und die Steuereinrichtung dazu eingerichtet ist, die Kurvenform des zeitlichen Verlaufs des durch den Leistungsschalter fließenden Momentanstroms hinsichtlich des Vorliegens mindestens eines die Kurvenform charakterisierenden Kriteriums zu untersuchen und anhand des Kriteriums auf einen andauernden oder einen unterbrochenen Stromfluss zu schließen.

Erfindungsgemäß ist vorgesehen, dass die Steuereinrichtung dazu eingerichtet ist, als Kriterium eine Periodizität des Verlaufs zu untersuchen und auf ein Andauern des Stromflusses durch den Leistungsschalter zu schließen, wenn eine Periodizität des Verlaufs erkannt wird, wobei die Steuereinrichtung dazu eingerichtet ist, bei fehlender Periodizität des Verlaufs als ein weiteres Kriterium ein Abklingverhalten des Verlaufs zu untersuchen und auf eine Unterbrechung des Stromflusses durch den Leistungsschalter zu schließen, wenn ein Abklingverhalten der Verlaufs erkannt wird.

Die Schutzeinrichtung kann dabei integraler Bestandteil eines Schutzgerätes sein, das einen von dem Leistungsschalter begrenzten Abschnitt des Energieversorgungsnetzes überwacht und im Fehlerfall das Auslösesignal an den Leistungsschalter abgibt. Alternativ kann die Schutzeinrichtung auch eine separate Einrichtung darstellen.

Hinsichtlich der erfindungsgemäßen Schutzeinrichtung gelten alle zu dem erfindungsgemäßen Verfahren voranstehend und nachfolgend gemachten Ausführungen und umgekehrt in entsprechender Weise, insbesondere ist die erfindungsgemäße Schutzeinrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Schutzeinrichtung wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: eine schematische Ansicht eines elektrischen Energieversorgungsnetzes;
- Figur 2: ein Ablaufschema eines Ausführungsbeispiels eines Verfahrens zum Überwachen eines Leistungsschalters;
- Figur 3: ein beispielhaftes Strom-Zeit-Diagramm zur Erläuterung des Kriteriums "Periodizität";
- Figur 4: ein weiteres beispielhaftes Strom-Zeit-Diagramm zur Erläuterung des Kriteriums "Abklingverhalten";
- Figur 5: ein weiteres beispielhaftes Strom-Zeit-Diagramm zur Erläuterung der Erkennung von durch Wandlersättigung beeinflussten Verläufen;
- Figur 6: ein weiteres beispielhaftes Strom-Zeit-Diagramm zur Erläuterung des Kriteriums "Amplitude";
- Figur 7: ein weiteres beispielhaftes Strom-Zeit-Diagramm zur Erläuterung der Erkennung von durch Oberschwingungen beeinflussten Verläufen; und
- Figur 8: ein beispielhaftes Strom-Zeit-Diagramm zur Erläuterung der Vorgehensweise zur adaptiven Festlegung der Länge eines Zeitfensters.

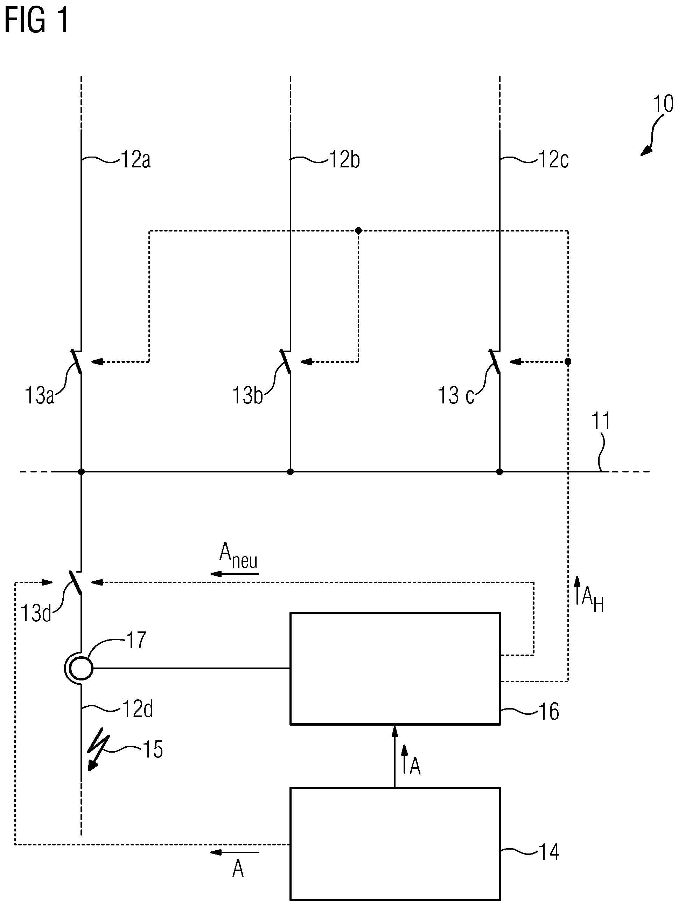

Figur 1 zeigt in schematischer Darstellung einen Teil 10 eines ansonsten nicht näher dargestellten elektrischen Energieversorgungsnetzes. Der Teil 10 umfasst eine Sammelschiene 11, die über drei Zuleitungen 12a-c gespeist wird. In den Zuleitungen befinden sich Leistungsschalter 13a-c, über die die Sammelschiene 11 von den jeweiligen Zuleitungen 12a-c abgetrennt werden kann. Die Sammelschiene 11 speist zudem eine Abzweigleitung 12d, die ebenfalls über einen Leistungsschalter 13d von der Sammelschiene 11 abgetrennt werden kann.

Die Abzweigleitung 12d wird von einem in Figur 1 nur schematisch angedeuteten Schutzgerät 14 hinsichtlich etwaiger Fehler, z.B. Kurzschlüsse, überwacht. Dazu nimmt das Schutzgerät an einer in Figur 1 nicht dargestellten Messstelle einen Betriebszustand der Abzweigleitung 12d charakterisierende Messwerte, z.B. Ströme und Spannungen, auf und wertet diese unter Verwendung sogenannter Schutzalgorithmen aus. Bei solchen Schutzalgorithmen kann es sich beispielsweise um einen Überstromschutz-, einen Distanzschutz- oder einen Differentialschutzalgorithmus handeln. Diese Schutzalgorithmen sind dem Fachmann im Umfeld der Überwachung elektrischer Energieversorgungsnetze geläufig und werden hier daher nicht eingehender behandelt.

Stellt das Schutzgerät 14 fest, dass die Abzweigleitung 12d an einer beispielhaft angedeuteten Fehlerstelle 15 einen Fehler aufweist, gibt es ein Auslösesignal A an den Leistungsschalter 13d ab, um diesen zum Öffnen seiner Schaltkontakte zu veranlassen und damit die Abzweigleitung 13d von der Sammelschiene 11 abzutrennen.

Üblicherweise wird dadurch der an der Fehlerstelle 15 fließende Strom abgeschaltet und damit der Fehler geklärt, so dass eine Fehlerbehebung durchgeführt werden kann. Der restliche Teil des Energieversorgungsnetzes kann derweil weiterbetrieben werden.

In Ausnahmefällen kann es jedoch vorkommen, dass der Fehlerstrom nicht abgeschaltet wird. Dies kann beispielsweise aufgrund eines Defekts des Leistungsschalters 13d oder einer gestörten Übermittlung des Auslösesignals A eintreten. Damit auch für diesen Fall die Stabilität des Energieversorgungsnetzes und die Sicherheit seines Betriebs gewährleistet werden kann, wird die ordnungsgemäße Funktionsweise des Leistungsschalters 13d mit einer Schutzeinrichtung 16 überwacht. Diese Schutzeinrichtung 16 kann entweder ein integraler Bestandteil des Schutzgerätes 14 oder als separate Einrichtung ausgebildet sein. Zur Durchführung der Überwachung weist die Schutzeinrichtung 16 eine Steuereinrichtung, z.B. einen Prozessor, auf. Sofern die Schutzeinrichtung 16 ein Bestandteil des Schutzgerätes 14 ist, kann sie hierfür auch auf einen Prozessor des Schutzgerätes 14 zurückgreifen.

Zur Überwachung, ob der Leistungsschalter 13d ordnungsgemäß abgeschaltet hat, untersucht die Schutzeinrichtung 16 den über den Leistungsschalter 13d nach Abgabe des Auslösesignals A fließenden Strom. Hierfür wird der Strom mit einem Stromwandler 17 erfasst und der Schutzeinrichtung 16 zugeführt. Üblicherweise werden hierzu ein oder mehrere analoge Stromsignale mittels eines A/D-Umsetzer in digitale Strommesswerte umgewandelt. Außerdem können weitere strombezogene Vorverarbeitungsschritte, z.B. eine Berechnung eines Erd- oder Gegensystemstroms, durchgeführt werden. Die betrachteten Strommesswerte können somit Phasenströme, ein Erdstrom (bzw. Nullsystemstrom) oder ein Gegensystemstrom sein. Außerdem wird der Schutzeinrichtung 16 auch das Auslösesignal A des Schutzgerätes 14 zugeführt, um den Beginn der Leistungsschalter-überwachung zu triggern.

Erkennt die Schutzeinrichtung 16 nach Ablauf einer maximalen Untersuchungsdauer einen andauernden Stromfluss über den Leistungsschalter 13d, so schließt sie auf einen Fehler des Leistungsschalters 13d und erzeugt ein Schalter-Fehlersignal. Dieses Schalter-Fehlersignal kann dazu verwendet werden, ein erneutes Auslösesignal Aₙₑᵤ an den Leistungsschalter 13d abzugeben, um damit einen zweiten Versuch zu unternehmen, den Leistungsschalter 13d zu öffnen. Alternativ oder zusätzlich kann das Schalter-Fehlersignal auch dazu verwendet werden ein Hilfs-Auslösesignal A_{H} an die dem Leistungsschalter 13d vorgelagerten Leistungsschalter 13a-c abzugeben, um diese zu öffnen und den Fehler somit abzuschalten. Da in diesem Fall die gesamt Sammelschiene stromlos geschaltet wird, ist die lokale Abschaltung über den Leistungsschalter 13d zu bevorzugen und die Abschaltung über die Leistungsschalter 13a-c nur für den Fall einzusetzen, dass über den Leistungsschalter 13d den Fehler nicht abgeschaltet werden kann. Es ist daher auch möglich, zunächst einen zweiten Versuch der lokalen Abschaltung über den Leistungsschalter 13d zu unternehmen und das Hilfs-Auslösesignal nur dann zu erzeugen, wenn auch nach Ablauf einer weiteren Zeitdauer der Stromfluss über den Leistungsschalter 13d nicht unterbrochen worden ist.

Zur schnellen und zuverlässigen Erkennung einer erfolgreichen Unterbrechung des Stromflusses über den Leistungsschalter 13d untersucht die Schutzeinrichtung 16 den zeitlichen Verlauf des Momentanstroms auf charakteristische Merkmale. Da somit die Kurvenform des Verlaufs im Zeitbereich betrachtet wird, muss keine zeitaufwendige Transformation in den Frequenzbereich stattfinden, so dass die Erkennung einer erfolgreichen Unterbrechung sehr schnell erfolgen kann.

Bei der Untersuchung der Kurvenform des Verlaufs nimmt die Schutzeinrichtung 16 eine Analyse vor, ob bestimmte Kriterien vorliegen, die einen Hinweis auf einen andauernden bzw. einen unterbrochenen Stromfluss geben.

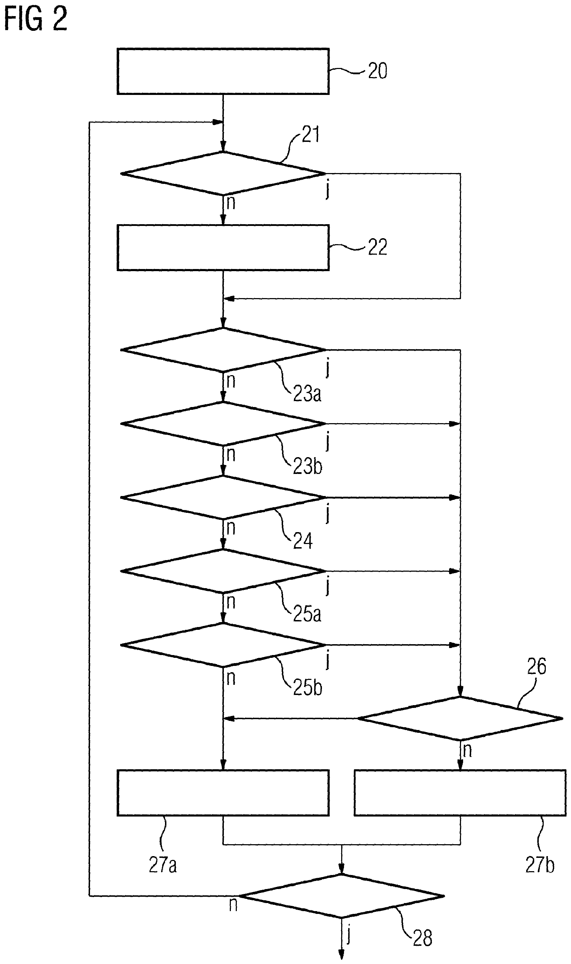

Die konkreten bei der Untersuchung zu berücksichtigenden Kriterien werden nachfolgend unter Hinzunahme von Figur 2 näher erläutert.

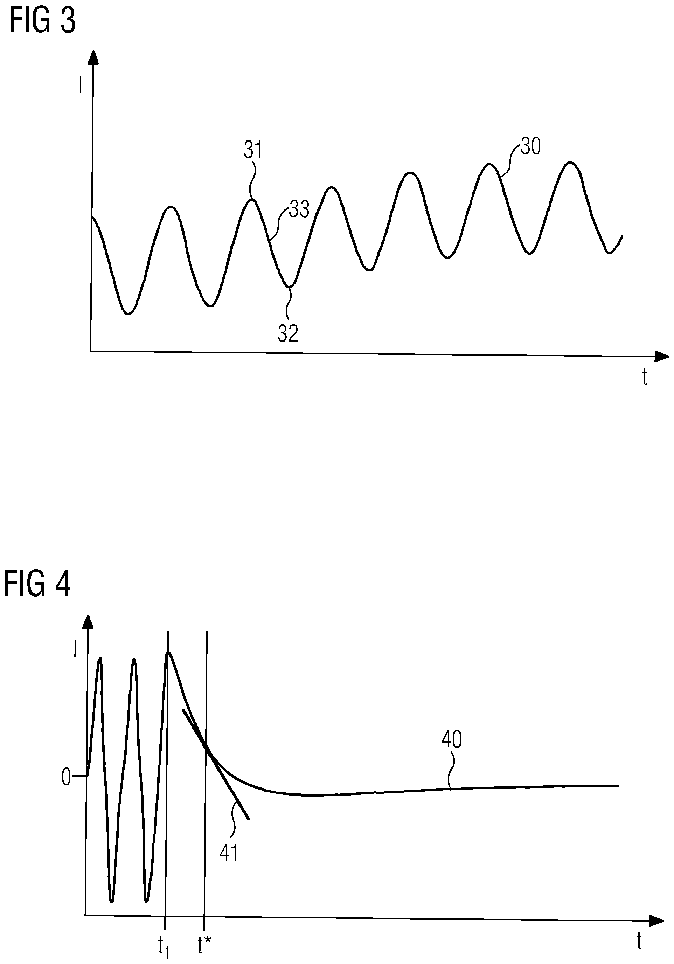

Figur 2 zeigt hierzu ein schematisches Ablaufdiagramm, anhand dessen die Vorgehensweise bei der Untersuchung des Stromflusses über den Leistungsschalter 13d erläutert werden soll. Zu einzelnen Kriterien wird außerdem ergänzend auf die Figuren 3 bis 8 Bezug genommen. Das im Zusammenhang mit Figur 2 erläuterte Verfahren wird üblicherweise als Software implementiert und von der Steuereinrichtung ausgeführt. Auch eine Hardware-Implementierung in Form eines FPGAs bzw. eines ASICs ist möglich. Die nachfolgenden Ausführungen beziehen sich auf ein mögliches Ausführungsbeispiel des Verfahrens zur Leistungsschalterüberwachung. Im Rahmen der Erfindung können einzelne oder mehrere Verfahrensschritte zu den erläuterten hinzutreten oder weggelassen werden.

Das in Figur 2 beispielhaft gezeigte Verfahren zur Leistungsschalterüberwachung wird in Schritt 20 gestartet. Die Aktivierung des Verfahrens erfolgt bei Empfang des Auslösesignals A von dem Schutzgerät 14 (vgl. Figur 1).

In einem folgenden Schritt 21 wird zunächst geprüft, ob eine Dauer einer Lernphase abgelaufen ist. Die Lernphase schließt sich unmittelbar an den Zeitpunkt der Abgabe des Auslösesignals A an. Ihre Dauer wird anhand der Reaktionszeit des Leistungsschalters 13d festgelegt, also derjenigen Zeit, die der Leistungsschalter 13d ab dem Empfang des Auslösesignals bis zum Öffnen seiner Schaltkontakte benötigt. Ist die Dauer der Lernphase noch nicht abgelaufen, so wird das Verfahren bei Schritt 22 fortgesetzt, andernfalls wird direkt zu Schritt 23a gesprungen.

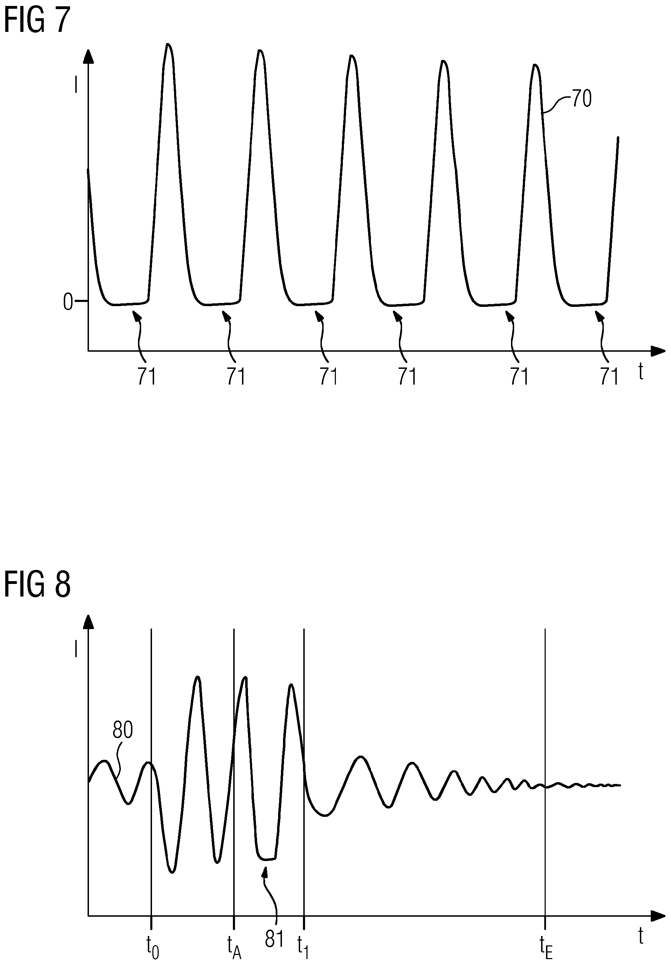

In Schritt 22 wird die Länge des zur Ermittlung der nachfolgend beschriebenen Kriterien verwendeten Zeitfensters adaptiv festgelegt. Dabei wird zunächst mit der kürzest möglichen Länge des Zeitfensters begonnen. In nachfolgenden Durchläufen des Verfahrens wird in Abhängigkeit vom Ergebnis der Untersuchung die Länge des Zeitfensters ggf. vergrößert. Die Festlegung der Länge des Zeitfensters wird später im Zusammenhang mit Figuren 7 und 8 eingehender erläutert.

In den Schritten 23a und 23b wird das Kriterium der "Periodizität" geprüft, d.h., es wird untersucht, ob die Kurvenform des Verlaufs des Momentanstroms Merkmale eines periodischen Signals aufweist. Ein periodischer Verlauf weist nämlich auf einen andauernden Stromfluss - und somit auf eine nicht stattgefundene Öffnung des Leistungsschalters - hin. Merkmale, die auf eine Periodizität einer Kurvenform hinweisen, sind insbesondere lokale Extrema (Maxima oder Minima) und Wendepunkte.

Bei im Wesentlichen sinusförmigen Kurvenverläufen, die üblicherweise bei einem Verlauf von Momentanströmen in einem Energieversorgungsnetz anzunehmen sind, treten in einem betrachteten Zeitfenster einer Länge von mindestens einer ¼ Periode der zu detektierenden Grundschwingung immer mindestens ein lokales Maximum 31, ein lokales Minimum 32 oder ein Wendepunkt 33 auf (vgl. beispielhaft eingetragene Punkte im Kurvenverlauf 30 der Figur 3). Die Erkennung dieser Merkmale kann anhand der ersten und zweiten zeitlichen Ableitung des Verlaufs des Momentanstroms bzw. anhand des jeweiligen Differenzenquotienten erfolgen.

Zunächst wird hierfür in Schritt 23a innerhalb des Zeitfensters mit der in Schritt 22 gewählten Länge das Vorliegen von lokalen Extrema überprüft. Bei einem lokalen Extremum haben die vor und nach dem Extremum liegenden Differenzenquotienten erster Ordnung (1. Ableitung) unterschiedliche Vorzeichen. Wird ein solcher Vorzeichenwechsel erkannt, so wird der Verlauf als periodisch angesehen und es wird direkt an Schritt 26 übergeben.

Wird in Schritt 23a kein lokales Extremum festgestellt, wird anschließend in Schritt 23b überprüft, ob ein Wendepunkt in dem betrachteten Zeitfenster liegt. Dazu wird der Verlauf des Differenzenquotienten zweiter Ordnung (2. Ableitung) überwacht. Findet ein Vorzeichenwechsel beim Differenzenquotienten zweiter Ordnung statt, so ist dies ein hinreichendes Kennzeichen für einen Wendepunkt und der Verlauf wird als periodisch angesehen. In diesem Fall wird von Schritt 23b direkt an Schritt 26 übergeben.

Zusammenfassend wird das betrachtete Signal als periodisch angesehen, wenn zumindest eines der vorgenannten Merkmale Minimum, Maximum oder Wendepunkt erkannt wird. In diesem Fall könnte ein weiter andauender Stromfluss vorliegen. Im Umkehrschluss wird eine Stromflussunterbrechung indiziert, wenn das Signal keine Merkmale der Periodizität aufweist.

Sofern der Kurvenverlauf keine Merkmale der Periodizität aufweist (d.h., es könnte eine Stromunterbrechung vorliegen), wird das Verfahren in Schritt 24 fortgesetzt. Hier wird geprüft, ob bereits in einem vorherigen Durchlauf der Untersuchung eine Stromunterbrechung festgestellt worden ist. Dies kann beispielsweise anhand eines im vorherigen Durchlauf des Verfahrens vergebenen "Flag" (Kennzeichnung) erkannt werden. Ist der aktuelle Durchlauf der erste Durchlauf oder wurde bisher noch keine Stromunterbrechung festgestellt, so wird die Untersuchung mit Schritt 25a fortgesetzt. Andernfalls (es wurde bereits zuvor eine Stromunterbrechung festgestellt) werden Schritte 25a und 25b übersprungen und es das Verfahren wird direkt mit Schritt 26 fortgesetzt. Die Überprüfung in Schritt 24 hat somit den Zweck, das Verfahren insgesamt zu straffen, wenn Hinweise für eine Stromunterbrechung existieren. In einem solchen Fall ist es ausreichend, die Periodizität des Verlaufs in Schritten 23a und 23b zu prüfen. Sofern diese nicht auf eine Wiederaufnahme des Stromflusses hinweisen, können die nachfolgenden Untersuchungsschritte 25a und 25b im aktuellen Durchgang ausgelassen werden. Die Prüfung in Schritt 24 kann sich dabei auf den unmittelbar vorangehenden Untersuchungsdurchlauf, auf eine bestimmte Anzahl vorangehender Untersuchungsdurchläufe (z.B. die letzten 3 Durchläufe) oder alle vorangehenden Durchläufe beziehen. Der Prüfungsalgorithmus ist an dieser Stelle entsprechend der Auswahl anzupassen.

Erfindungsgemäß ist weiter vorgesehen, dass bei fehlender Periodizität des Verlaufs ein Abklingverhalten des Verlaufs untersucht wird und auf eine Unterbrechung des Stromflusses durch den Leistungsschalter geschlossen wird, wenn ein Abklingverhalten des Verlaufs erkannt wird. Neben der Periodizität des Verlaufs stellt auch das Kriterium des Vorliegens eines Abklingverhaltens ein wesentliches Kriterium dar, anhand dessen eine Entscheidung darüber getroffen werden kann, ob der Stromfluss andauert oder unterbrochen worden ist. Häufig treten nämlich nach der Stromabschaltung Abklingprozesse auf. Da diese relativ stromstark sein können, kann die Erkennung des Stromrückganges beeinflusst und stark verzögert werden. Mit dem nachfolgend vorgeschlagenen Kriterium sind diese jedoch gut beherrschbar und führen zu keiner Verzögerung des Verfahrens, da die Abklingprozesse sich mit den genannten Kriterien sehr gut identifizieren und von anderen Phänomenen wie der Sättigung unterscheiden lassen.

Dies wird anhand eines beispielhaften Verlaufs 40 in Figur 4 erläutert. Mit Öffnen der Schaltkontakte des Leistungsschalters zum Zeitpunkt t=t₁ weist der in Figur 4 dargestellte Verlauf 40 einerseits keine Merkmale der Periodizität mehr auf und klingt andererseits langsam ab. Ein solches Abklingverhalten weist neben der Tatsache der fehlenden Periodizität auf einen unterbrochenen Stromfluss hin.

Um ein Abklingverhalten erkennen zu können, ist somit der Gradient des Verlaufs zu betrachten. Ist dieser in dem betrachteten Zeitfenster dauerhaft positiv oder negativ, weist dies auf ein vorliegendes Abklingverhalten hin. Figur 4 zeigt hierzu lediglich beispielhaft den Gradienten 41 des Verlaufs zum Zeitpunkt t=t*.

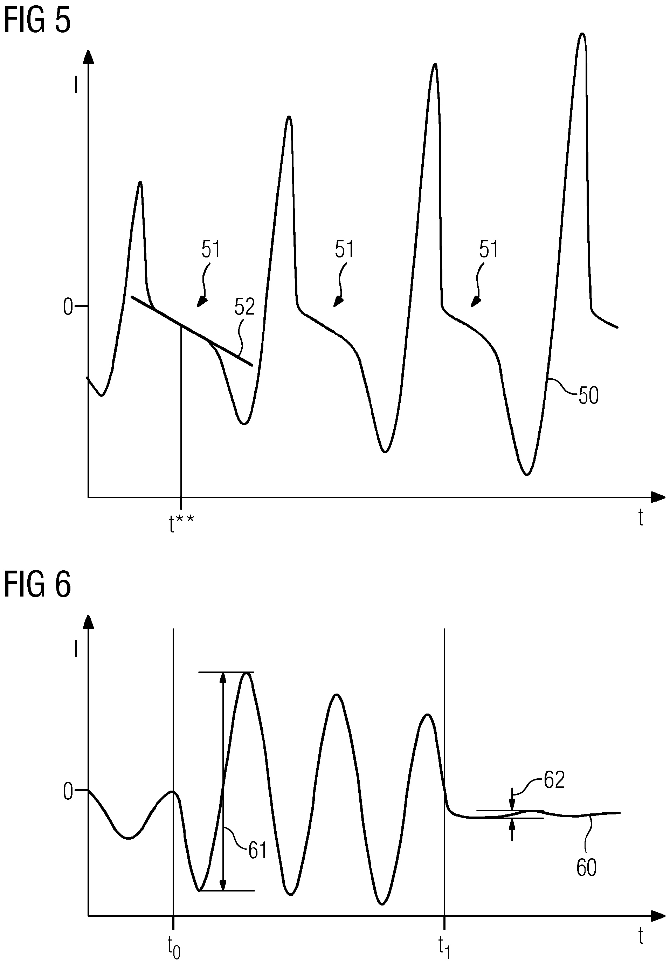

Eine Schwierigkeit bei der alleinigen Betrachtung des Gradienten des Verlaufs besteht darin, dass auch im Falle einer vorhandenen Wandlersättigung Bereiche des Verlaufs des Momentanstroms auftreten können, die durch einen dauerhaft positiven oder negativen Gradienten geprägt sind. Dies ist beispielhaft in Figur 5 illustriert.

Der in Figur 5 dargestellte Verlauf 50 zeigt ein an sich periodisches Signal, das aufgrund von Wandlersättigung in bestimmten Bereichen (z.B. Bereiche 51) keine Merkmale der Periodizität, sondern stattdessen einen dauerhaft negativen Gradienten aufweist. Beispielhaft ist der zum Zeitpunkt t=t** vorliegende Gradient 52 eingetragen. Erfasst das betrachtete Zeitfenster im Fall der Figur 5 keines der vorliegenden lokalen Extrema und keinen Wendepunkt, so könnte bei alleiniger Betrachtung des Gradienten fehlerhaft auf ein vorliegendes Abklingverhalten geschlossen werden.

Das Kriterium des Abklingverhaltens wird daher um das Merkmal ergänzt, dass nur dann auf ein vorliegendes Abklingverhalten geschlossen werden darf, wenn ein negativer Gradient gemeinsam mit einem (über das Zeitfenster betrachtet) positiven Strommittelwert oder ein positiver Gradient gemeinsam mit einem negativen Strommittelwert auftritt. Der Strommittelwert wird dabei bevorzugt als arithmetisches Mittel berechnet. Wie beim Vergleich der Figuren 4 und 5 erkannt werden kann, liegt ein solches Fall zwar bei dem Verlauf 40 in Figur 4 vor, beim Verlauf 50 in Figur 5 treten jedoch ein negativer Gradient und ein negativer Strommittelwert gemeinsam auf.

Daher wird zur Untersuchung des Verlaufs des Momentanstroms in Schritt 25a zunächst geprüft, ob ein positiver Gradient gemeinsam mit einem positiven Strommittelwert (in dem betrachteten Zeitfenster) vorliegt. Ist dies der Fall, deutet dies auf eine vorliegende Sättigung hin und das Verfahren wird bei Schritt 26 fortgesetzt. Ist die Voraussetzung von Schritt 25a nicht erfüllt, so wird das Verfahren in Schritt 25 mit der umgekehrten Prüfung fortgesetzt, nämlich ob ein negativer Gradient gemeinsam mit einem negativen Strommittelwert vorliegt. Ist dies der Fall, deutet dies auf eine vorliegende Sättigung hin und das Verfahren wird bei Schritt 26 fortgesetzt. Ist die Voraussetzung von Schritt 25b nicht erfüllt, so müssen Gradient und Strommittelwert unterschiedliche Vorzeichen haben, was auf ein vorliegendes Abklingverhalten hindeutet.

Sofern in Schritten 23a und 23b keine Periodizität und in Schritten 25a und 25b ein vorliegendes Abklingverhalten festgestellt worden sind, kann davon ausgegangen werden, dass der Stromfluss wie gewünscht unterbrochen worden ist. In Schritt 27a wird somit für den aktuellen Durchlauf der Untersuchung die Entscheidung getroffen, dass eine Unterbrechung des Stromflusses vorliegt, d.h., dass der Leistungsschalter geöffnet ist. Hierzu kann beispielsweise ein entsprechendes Flag gesetzt werden, das eine Unterbrechung des Stromflusses angibt und im weiteren Verlauf des Verfahrens (z.B. bei Schritt 28 oder in einem Folgedurchlauf in Schritt 24) herangezogen wird. Die Untersuchung wird nachfolgend in Schritt 28 fortgesetzt.

Schritt 26 wird ausgeführt, wenn bei einer der vorhergehenden Prüfungen ein Hinweis auf einen andauernden Stromfluss erkannt worden ist. Dies ist insbesondere dann der Fall, wenn der Verlauf periodisch ist oder wenn kein Abklingverhalten festgestellt werden konnte. In Schritt 26 wird eine Amplitude des Verlaufs ermittelt und mit einem Amplituden-Schwellenwert verglichen. Zur einfacheren Ermittlung der Amplitude kann diese als Abstand zweier aufeinanderfolgender lokaler Extrema (Spitze-Spitze-Amplitude bzw. "Peak-to-Peak") bestimmt werden. Dies ist in Figur 6 näher erläutert.

Figur 6 zeigt einen beispielhaften Verlauf 60 eines Momentanstroms. Zum Zeitpunkt t=t₀ tritt ein Fehler ein, der zum Zeitpunkt t=t₁ durch Öffnen der Schaltkontakte des Leistungsschalters abgeschaltet wird. Man erkennt während der Dauer des anstehenden Fehlers eine vergleichsweise große Spitze-Spitze-Amplitude 61; nach dem Abschalten des Fehlers weist der Verlauf 60 hingegen nur noch eine signifikant niedrigere Spitze-Spitze-Amplitude 62 auf.

Ergibt die Überprüfung der Spitze-Spitze-Amplitude in dem betrachteten Zeitfenster des Verlaufs in Schritt 26 somit, dass diese unterhalb des Amplituden-Schwellenwertes liegt, so wird auf eine Unterbrechung des Stromflusses geschlossen und das Verfahren bei Schritt 27a (s.o.) fortgesetzt.

Gemäß der Darstellung in Figur 2 ist das Kriterium der Amplitude als führend gegenüber dem Periodizitätskriterium ausgestaltet, d.h., es wird selbst dann auf eine Unterbrechung geschlossen, wenn noch Anzeichen einer Periodizität erkannt werden können. In diesem Fall ist das Amplitudenkriterium entsprechend streng zu wählen, d.h. es ist ein kleiner Schwellenwert vorzugeben, der mit hoher Sicherheit auf einen unterbrochenen Stromfluss hindeutet. Andere Ausgestaltungen, bei denen die Kriterien der Periodizität und der Amplitude gleichgeordnet behandelt werden, sind jedoch ebenfalls denkbar.

Wird hingegen in Schritt 26 festgestellt, dass der Amplituden-Schwellenwert nicht unterschritten ist, so deutet dies - neben der vorliegenden Periodizität und dem fehlenden Abklingverhalten - auf einen andauernden Stromfluss hin. Entsprechend wird im nachfolgenden Schritt 27b ein andauernder Stromfluss erkannt und beispielsweise durch Vergabe eines entsprechenden Flags gekennzeichnet. Danach wird das Verfahren bei Schritt 28 fortgesetzt.

In Schritt 28 wird geprüft, ob die Dauer der Untersuchungszeit abgelaufen ist. Ist dies der Fall, wird das Verfahren beendet und es wird die aktuelle Entscheidung darüber, ob eine Stromunterbrechung (Schritt 27a) oder ein andauernder Stromfluss (Schritt 27b) vorliegt, ausgegeben. Sofern ein andauernder Stromfluss festgestellt worden ist, wird von der Schutzeinrichtung das Schalter-Fehlersignal (vgl. Figur 1) erzeugt. Ist die Untersuchungszeitdauer hingegen noch nicht abgelaufen, so wird ein neuer Durchlauf des Verfahrens bei Schritt 21 gestartet. Dabei wird die in Schritten 27a bzw. 27b getroffene Entscheidung, z.B. durch Setzen des entsprechenden Flags, übergeben.

Abschließend soll die Vorgehensweise bei der adaptiven Festlegung der Länge des Zeitfensters (Schritt 22) erläutert werden.

Wie Figur 7 entnommen werden kann, können Fälle auftreten, in denen ein Verlauf des Momentanstroms in bestimmten Bereichen, die bis zu einer halben Periodendauer anstehen können, weder Anzeichen einer Periodizität aufweist, noch eine Amplitude besitzt, die über einem Amplituden-Schwellenwert liegt. Dies kann insbesondere dann auftreten, wenn signifikante Anteile harmonischer Oberschwingungen auftreten. Figur 7 zeigt hierzu beispielhaft einen Verlauf 70, der - bedingt durch Überlagerung mit Oberschwingungen - Bereiche 71 aufweist, die sich durch fehlende Periodizität und eine Amplitude nahe Null auszeichnen. Entsprechend der voranstehenden Erläuterungen würde dies - bei ungünstiger Länge und Position der Zeitfenster - auf eine Unterbrechung des Stromflusses hindeuten, die in Realität jedoch nicht gegeben ist. Daher ist die geeignete Auswahl der Länge des Zeitfensters, insbesondere beim Vorhandensein von Oberschwingungen, maßgeblich für eine zuverlässige Durchführung des Verfahrens zum Überwachen des Leistungsschalters. Bei fehlenden Oberschwingungen hingegen würde ein statisches zu lang gewähltes Zeitfenster die Zeit bis zur Entscheidung unnötig lang verzögern.

Daher wird das Zeitfenster adaptiv an die Gegebenheiten des Verlaufs angepasst. Hierzu wird während der sich an den Zeitpunkt der Abgabe des Auslösesignals unmittelbar anschließenden Lernphase die Untersuchung wie in Figur 2 dargestellt durchgeführt. Sofern jedoch während der Lernphase eine Unterbrechung des Stromflusses erkannt wird, wird für den nachfolgenden Durchlauf des Verfahrens das Zeitfenster verlängert. Dieser Vorgehensweise liegt die Überlegung zugrunde, dass während der Lernphase, d.h. vom Zeitpunkt der Abgabe des Auslösesignals bis zum tatsächlichen Öffnen der Schaltkontakte des Leistungsschalters keine Unterbrechung des Stromflusses auftreten kann, da die Schaltkontakte in diesem Zeitraum noch nicht geöffnet sind. Sofern in der Lernphase eine Unterbrechung des Stromflusses erkannt wird, kann dies folglich nur auf eine ungeeignete Auswahl der Länge des Zeitfensters zurückzuführen sein. Daher wird die Länge des Zeitfensters in der Folge heraufgesetzt, bis die Ergebnisse erwartungsgemäß einen andauernden Stromfluss angeben. Nach Ende der Lernphase wird die Länge des Zeitfensters festgeschrieben, da ab dann eine Unterbrechung des Stromflusses tatsächlich auftreten kann. Typische Werte der Dauer der Lernphase liegen bei etwa 1,5 Periodendauern.

Diese Vorgehensweise soll abschließend kurz anhand von Figur 8 verdeutlicht werden. Figur 8 zeigt einen beispielhaften Verlauf 80 eines Momentanstroms. Man erkennt zum Zeitpunkt t=t₀ einen Fehlereintritt, der unter anderem mit einem sprunghaften Anstieg der Amplitude des Verlaufs einhergeht. Zum Zeitpunkt t=t_{A} erkennt der Schutzalgorithmus des Schutzgeräts das Vorliegen des Fehlers und gibt das Auslösesignal A ab. Hierdurch wird der Beginn der Lernphase festgelegt. Zum Zeitpunkt t=t₁ öffnet der Leistungsschalter seine Schaltkontakte, wodurch das Ende der Lernphase festgelegt wird. Die Dauer der Lernphase wird in Abhängigkeit der Reaktionszeit des Leistungsschalters gewählt. Diese Reaktionszeit des Leistungsschalters liegt üblicherweise als charakteristische Eigenschaft des Leistungsschalters fest und wird vom Schalterhersteller in den technischen Daten des Leistungsschalters angegeben.

Innerhalb der Lernphase liegt ein durch Oberschwingungen beeinflusster Bereich des Verlaufs 80, der bei zu kurzer Wahl der Länge des Zeitfensters die Erkennung einer Unterbrechung des Stromflusses herbeiführen könnte. Da jedoch für die Lernphase das Vorliegen einer Stromflussunterbrechung ausgeschlossen wird, wird wie oben erläutert das Zeitfenster durch entsprechende Erhöhung seiner Länge adaptiv angepasst. Zum Zeitpunkt t=t₁ muss die Festlegung der Länge des Zeitfensters abgeschlossen sein; ab diesem Zeitpunkt können sowohl eine Unterbrechung des Stromflusses als auch ein andauernder Stromfluss erkannt werden.

Zum Zeitpunkt t=t_{E} ist die Untersuchungszeitdauer abgelaufen. Sofern zu diesem Zeitpunkt noch ein andauernder Stromfluss festgestellt worden ist, wird das Schalter-Fehlersignal mit den oben erläuterten Folgen erzeugt. Im Beispiel der Figur 8 liegt zwar weiterhin eine Periodizität des Verlaufs vor, jedoch nimmt seine Amplitude kontinuierlich ab und liegt zum Ende der Untersuchungszeitdauer unterhalb des Amplituden-Schwellenwertes, so dass eine Unterbrechung des Stromflusses erkannt wird und dementsprechend kein Schalter-Fehlersignal erzeugt wird.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Überwachen eines Leistungsschalters (13d) in einem elektrischen Energieversorgungsnetz, bei dem
- ein Abschnitt des elektrischen Energieversorgungsnetzes hinsichtlich des Auftretens eines Fehlers überwacht wird;
- bei Erkennung eines Fehlers auf dem überwachten Abschnitt ein Auslösesignal an einen den Abschnitt begrenzenden Leistungsschalter (13d) abgegeben wird; und
- ein einen Fehler beim Öffnen des Leistungsschalters (13d) angebendes Schalter-Fehlersignal erzeugt wird, wenn nach der Abgabe des Auslösesignals ein andauernder Stromfluss durch den Leistungsschalter (13d) erkannt wird, wobei
- zum Erkennen eines andauernden Stromflusses eine Kurvenform des zeitlichen Verlaufs des durch den Leistungsschalter (13d) fließenden Momentanstroms untersucht wird und
- die Kurvenform des zeitlichen Verlaufs des durch den Leistungsschalter (13d) fließenden Momentanstroms hinsichtlich des Vorliegens mindestens eines die Kurvenform charakterisierenden Kriteriums untersucht wird; und
- anhand des Kriteriums auf einen andauernden oder einen unterbrochenen Stromfluss geschlossen wird; wobei
- als Kriterium eine Periodizität des Verlaufs untersucht wird; und
- auf ein Andauern des Stromflusses durch den Leistungsschalter (13d) geschlossen wird, wenn eine Periodizität des Verlaufs erkannt wird,
**dadurch gekennzeichnet, dass**
- bei fehlender Periodizität des Verlaufs als ein weiteres Kriterium ein Abklingverhalten des Verlaufs untersucht wird; und
- auf eine Unterbrechung des Stromflusses durch den Leistungsschalter (13d) geschlossen wird, wenn ein Abklingverhalten des Verlaufs erkannt wird.

2. Verfahren nach Anspruch 1,
**dadurch gekennzeichnet, dass**
- die Periodizität des Verlaufs anhand von auftretenden lokalen Extrema und/oder Wendepunkten untersucht wird.

3. Verfahren nach Anspruch 2,
**dadurch gekennzeichnet, dass**
- zur Erkennung eines Abklingverhaltens einerseits der Mittelwert des Verlaufs des Momentanstroms und andererseits der Gradient des Verlaufs des Momentanstroms untersucht werden; und
- bei positivem Mittelwert und negativem Gradienten oder bei negativem Mittelwert und positivem Gradienten auf ein vorliegendes Abklingverhalten geschlossen wird.

4. Verfahren nach einem der vorangehenden Ansprüche,
**dadurch gekennzeichnet, dass**
- als ein weiteres Kriterium eine Amplitude des Verlaufs ermittelt wird; und
- auf eine Unterbrechung des Stromflusses durch den Leistungsschalter (13d) geschlossen wird, wenn die Amplitude des Verlaufs einen Amplituden-Schwellenwert unterschreitet.

5. Verfahren nach Anspruch 4,
**dadurch gekennzeichnet, dass**
- die Amplitude als Spitze-Spitze-Amplitude des Verlaufs ermittelt wird.

6. Verfahren nach Anspruch 4 oder 5,
**dadurch gekennzeichnet, dass**
- bei einer unter dem Amplituden-Schwellenwert liegenden Amplitude des Verlaufs auch dann auf eine Unterbrechung des Stromflusses geschlossen wird, wenn eine Periodizität des Verlaufs erkannt worden ist.

7. Verfahren nach einem der vorangehenden Ansprüche,
**dadurch gekennzeichnet, dass**
- der Verlauf innerhalb eines vorgegebenen Zeitfensters untersucht wird, wobei
- die Länge des Zeitfensters adaptiv festgelegt wird.

8. Verfahren nach Anspruch 7,
**dadurch gekennzeichnet, dass**
- zur adaptiven Festlegung der Länge des Zeitfensters die Untersuchung zunächst mit einer minimalen Länge des Zeitfensters begonnen wird; und
- die Länge des Zeitfensters so lange erhöht wird, wie während einer unmittelbar auf den Zeitpunkt der Abgabe des Ausschaltsignals folgenden Lernphase eine Unterbrechung des Stromflusses erkannt wird, wobei die Dauer der Lernphase in Abhängigkeit von der Reaktionszeit des Leistungsschalters (13d) festgelegt wird.

9. Verfahren nach einem der vorangehenden Ansprüche,
**dadurch gekennzeichnet, dass**
- die Untersuchung der Kurvenform des Verlaufs während einer Untersuchungsdauer wiederholt durchgeführt wird; und
- das Schalter-Fehlersignal erzeugt wird, wenn am Ende der Untersuchungsdauer ein andauernder Stromfluss festgestellt wird.

10. Verfahren nach Anspruch 9,
**dadurch gekennzeichnet, dass**
- die Auswahl der für die Untersuchung des Verlaufs zu betrachtenden Kriterien davon abhängt, ob in einem vorangehenden Durchgang der Untersuchung bereits eine Unterbrechung des Stromflusses erkannt worden ist.

11. Verfahren nach einem der vorangehenden Ansprüche,
**dadurch gekennzeichnet, dass**
- bei vorliegendem Schalter-Fehlersignal ein erneutes Auslösesignal an den Leistungsschalter (13d) abgegeben wird und/oder ein Hilfs-Auslösesignal an zumindest einen dem Leistungsschalter (13d) vorgelagerten weiteren Leistungsschalter (13a-c) abgegeben wird.

12. Schutzeinrichtung (16) zum Überwachen eines Leistungsschalters (13d) in einem elektrischen Energieversorgungsnetz, mit einer Steuereinrichtung, die dazu eingerichtet ist,
- ein einen Fehler beim Öffnen eines Leistungsschalters (13d) angebendes Schalter-Fehlersignal zu erzeugen, wenn nach der Abgabe des Auslösesignals für den Leistungsschalter (13d) ein andauernder Stromfluss durch den Leistungsschalter (13d) erkannt wird, wobei
- die Steuereinrichtung dazu eingerichtet ist, zum Erkennen eines andauernden Stromflusses eine Kurvenform des zeitlichen Verlaufs des durch den Leistungsschalter (13d) fließenden Momentanstroms zu untersuchen; und
- die Steuereinrichtung dazu eingerichtet ist,
die Kurvenform des zeitlichen Verlaufs des durch den Leistungsschalter (13d) fließenden Momentanstroms hinsichtlich des Vorliegens mindestens eines die Kurvenform charakterisierenden Kriteriums zu untersuchen und anhand des Kriteriums auf einen andauernden oder einen unterbrochenen Stromfluss zu schließen; wobei
- die Steuereinrichtung dazu eingerichtet ist, als Kriterium eine Periodizität des Verlaufs zu untersuchen und auf ein Andauern des Stromflusses durch den Leistungsschalter (13d) zu schließen, wenn eine Periodizität des Verlaufs erkannt wird,
**dadurch gekennzeichnet, dass**
- die Steuereinrichtung dazu eingerichtet ist, bei fehlender Periodizität des Verlaufs als ein weiteres Kriterium ein Abklingverhalten des Verlaufs zu untersuchen und auf eine Unterbrechung des Stromflusses durch den Leistungsschalter (13d) zu schließen, wenn ein Abklingverhalten des Verlaufs erkannt wird.

## Claims

1. Method for monitoring a circuit breaker (13d) in an electrical power supply network, in which
- one section of the electrical power supply network is monitored in respect of the occurrence of a fault;
- upon detection of a fault in the monitored section a trip signal is output to a circuit breaker (13d) bordering the section; and
- a switch fault signal indicating a fault upon opening the circuit breaker (13d) is generated if a continuous flow of current through the circuit breaker (13d) is detected after the trip signal is output, wherein
- a curve shape of the time characteristic of the instantaneous current flowing through the circuit breaker (13d) is examined in order to detect a continuous flow of current and
- the curve shape of the time characteristic of the instantaneous current flowing through the circuit breaker (13d) is examined in respect of the presence of at least one criterion characterizing the curve shape; and
- the criterion is used as a basis for deducing a continuous flow of current or an interrupted flow of current; wherein
- the criterion examined is a periodicity of the characteristic; and
- the flow of current through the circuit breaker (13d) is deduced to be continuous if a periodicity of the characteristic is detected,
**characterized in that**
- a decay behaviour of the characteristic is examined as a further criterion in the absence of a periodicity of the characteristic; and
- an interruption to the flow of current through the circuit breaker (13d) is deduced if a decay behaviour of the characteristic is detected.

2. Method according to Claim 1,
**characterized in that**
- the periodicity of the characteristic is examined on the basis of local extremes and/or inflection points that occur.

3. Method according to Claim 2,
**characterized in that**
- firstly the mean value of the characteristic of the instantaneous current and secondly the gradient of the characteristic of the instantaneous current are examined in order to detect a decay behaviour; and
- the presence of a decay behaviour is deduced if the mean value is positive and the gradient is negative or if the mean value is negative and the gradient is positive.

4. Method according to one of the preceding claims, **characterized in that**
- a further criterion examined is an amplitude of the characteristic; and
- an interruption to the flow of current through the circuit breaker (13d) is deduced if the amplitude of the characteristic is below an amplitude threshold value.

5. Method according to Claim 4,
**characterized in that**
- the amplitude is determined as a peak-to-peak amplitude of the characteristic.

6. Method according to Claim 4 or 5,
**characterized in that**
- an interruption to the flow of current is also deduced when the amplitude of the characteristic is below the amplitude threshold value if a periodicity of the characteristic has been detected.

7. Method according to one of the preceding claims,
**characterized in that**
- the characteristic is examined within a predefined time window, wherein
- the length of the time window is adaptively stipulated.

8. Method according to Claim 7,
**characterized in that**
- the examination is initially started with a minimum length of the time window in order to adaptively stipulate the length of the time window; and
- the length of the time window is increased for as long as an interruption to the flow of current is detected during a learning phase that immediately follows the point in time at which the switch-off signal is output, wherein the duration of the learning phase is stipulated on the basis of the reaction time of the circuit breaker (13d).

9. Method according to one of the preceding claims,
**characterized in that**
- the examination of the curve shape of the characteristic is carried out repeatedly during an examination period; and
- the switch fault signal is generated if a continuous flow of current is discovered at the end of the examination period.

10. Method according to Claim 9,
**characterized in that**
- the selection of the criteria to be considered for the examination of the characteristic depends on whether an interruption to the flow of current has already been detected in a previous run of the examination.

11. Method according to one of the preceding claims,
**characterized in that**
- if a switch fault signal is present a fresh trip signal is output to the circuit breaker (13d) and/or an auxiliary trip signal is output to at least one further circuit breaker (13a-c) connected upstream of the circuit breaker (13d).

12. Protective device (16) for monitoring a circuit breaker (13d) in an electrical power supply network, comprising a control device, which is designed to
- generate a switch fault signal indicating a fault upon opening a circuit breaker (13d) if a continuous flow of current through the circuit breaker (13d) is detected after the trip signal for the circuit breaker (13d) is output, wherein
- the control device is designed to examine a curve shape of the time characteristic of the instantaneous current flowing through the circuit breaker (13d) in order to detect a continuous flow of current; and
- the control device is designed to examine the curve shape of the time characteristic of the instantaneous current flowing through the circuit breaker (13d) in respect of the presence of at least one criterion characterizing the curve shape and to use the criterion as a basis for deducing a continuous flow of current or an interrupted flow of current; wherein
- the control device is designed to examine a periodicity of the characteristic as the criterion and to deduce the flow of current through the circuit breaker (13d) to be continuous if a periodicity of the characteristic is detected,
**characterized in that**
- the control device is designed to examine a decay behaviour of the characteristic as a further criterion in the absence of a periodicity of the characteristic and to deduce an interruption to the flow of current through the circuit breaker (13d) if a decay behaviour of the characteristic is detected.

## Revendications

1. Procédé de contrôle d'un disjoncteur (13d) dans un réseau d'alimentation en énergie électrique, dans lequel
- on contrôle un tronçon du réseau d'alimentation en énergie électrique du point de vue de l'apparition d'un défaut ;
- à la détection d'un défaut sur le tronçon contrôlé, on donne un signal de déclenchement à un disjoncteur (13d) délimitant le tronçon ; et
- on produit un signal d'erreur de disjoncteur indiquant un défaut à l'ouverture du disjoncteur (13d), si on détecte après l'émission du signal de déclenchement un flux de courant persistant dans le disjoncteur (13d), dans lequel
- pour la détection d'un flux de courant persistant, on étudie une forme de courbe du tracé en fonction du temps du courant instantané passant dans le disjoncteur (13d) ; et
- on étudie la forme de courbe du tracé en fonction du temps du courant instantané passant dans le disjoncteur (13d) du point de vue de la présence d'au moins un critère caractérisant la forme de courbe ; et
- à l'aide du critère, on déduit un flux de courant persistant ou interrompu ; dans lequel
- comme critère, on étudie une périodicité du tracé ; et
- on déduit de la persistance du flux du courant dans le disjoncteur (13d) qu'une périodicité du tracé est détectée, **caractérisé en ce que**,
- en l'absence d'une périodicité du tracé, on étudie comme autre critère un comportement de décroissance du tracé ; et
- d'une interruption du flux de courant dans le disjoncteur (13d), on déduit qu'un comportement de décroissance du tracé est détecté.

2. Procédé suivant la revendication 1,
**caractérisé en ce que**
- on étudie la périodicité du tracé à l'aide de l'apparition d'extrèmum locaux et/ou de points d'inflexion.

3. Procédé suivant la revendication 2,
**caractérisé en ce que**
- pour la détection d'un comportement de décroissance, on étudie d'une part la valeur moyenne du tracé du courant instantané et d'autre part le gradient du tracé du courant instantané ; et
- si la valeur moyenne est positive et le gradient est négatif, ou si la valeur moyenne est négative et le gradient est positif, on déduit qu'il y a un comportement de décroissance.

4. Procédé suivant l'une des revendications précédentes,
**caractérisé en ce que**
- on détermine comme autre critère une amplitude du tracé ; et
- d'une interruption du flux de courant dans le disjoncteur (13d), on déduit que l'amplitude du tracé est inférieure à une valeur de seuil d'amplitude.

5. Procédé suivant la revendication 4,
**caractérisé en ce que**
- on détermine l'amplitude comme une amplitude de crête à crête du tracé.

6. Procédé suivant la revendication 4 ou 5,
**caractérisé en ce que**
- pour une amplitude du tracé se trouvant en dessous de la valeur de seuil de l'amplitude, on déduit également d'une interruption du flux de courant, qu'une périodicité du tracé a été détectée.

7. Procédé suivant l'une des revendications précédentes,
**caractérisé en ce que**
- on étudie le tracé dans un créneau temporel donné à l'avance, dans lequel
- on fixe de manière adaptative la longueur du créneau temporel.

8. Procédé suivant la revendication 7,
**caractérisé en ce que**
- pour la fixation de manière adaptative de la longueur du créneau temporel, on commence l'étude d'abord à une longueur minimum du créneau temporel ; et
- on augmente la longueur du créneau temporel jusqu'à ce que, pendant une phase d'apprentissage suivant immédiatement l'instant de l'émission du signal d'arrêt, on détecte une interruption du flux de courant, la durée de la phase d'apprentissage étant fixée en fonction du temps de réaction du disjoncteur (13d).

9. Procédé suivant l'une des revendications précédentes,
**caractérisé en ce que**
- on effectue de manière répétée l'étude de la forme de courbe du tracé pendant une durée d'étude ; et
- on produit le signal de défaut du disjoncteur, si l'on constate un flux de courant persistant à la fin de la durée de l'étude.

10. Procédé suivant la revendication 9,
**caractérisé en ce que**
- le choix des critères à considérer pour l'étude du tracé dépend du point de savoir si on a déjà détecté une interruption du flux de courant dans une passe précédente.

11. Procédé suivant l'une des revendications précédentes,
**caractérisé en ce que**,
- en présence d'un signal de défaut du disjoncteur, on donne au disjoncteur (13d) un signal de déclenchement renouvelé et/ou on donne un signal de déclenchement auxiliaire au au moins un autre disjoncteur (13a-a) monté avant le disjoncteur (13d) .

12. Dispositif (16) de protection pour contrôler un disjoncteur (13d) dans un réseau d'alimentation en énergie électrique, comprenant un dispositif de commande qui est conçu pour,
- produire un signal d'erreur de disjoncteur indiquant un défaut à l'ouverture d'un disjoncteur (13d) si, après l'émission du signal de déclenchement pour le disjoncteur (13d), on détecte un flux de courant persistant dans le disjoncteur (13d), dans lequel
- le dispositif de commande est conçu pour l'étude, pour la détection d'un flux de courant persistant, d'une forme de courbe du tracé en fonction du temps du courant instantané passant dans le disjoncteur (13d) ; et
- le dispositif de commande est conçu
pour étudier la forme de courbe du tracé en fonction du temps du courant instantané passant dans le disjoncteur (13d), du point de vue de la présence d'au moins un critère caractérisant la forme de courbe et pour déduire, à l'aide du critère, d'un flux de courant persistant ou interrompu ; dans lequel
- le dispositif de commande est conçu pour étudier comme critère une périodicité du tracé et pour déduire d'une persistance du flux de courant dans le disjoncteur (13d), s'il est détecté une périodicité du tracé,
**caractérisé en ce que**
- le dispositif de commande est conçu de manière à ce que, s'il n'y a pas une périodicité du tracé, à étudier comme autre critère un comportement de décroissance de tracé et à déduire d'une interruption du flux de courant dans le disjoncteur (13d), qu'il est détecté un comportement de décroissance du tracé.
